(19) Europäisches Patentamt
European Patent Office
Office européen des brevets

(11) **EP 4 016 849 A1**

(12) # EUROPEAN PATENT APPLICATION
published in accordance with Art. 153(4) EPC

(43) Date of publication:
**22.06.2022 Bulletin 2022/25**

(21) Application number: **20851881.1**

(22) Date of filing: **17.07.2020**

(51) International Patent Classification (IPC):
***H03M 13/11*** *(2006.01)* ***H04L 1/00*** *(2006.01)*

(52) Cooperative Patent Classification (CPC):
**H03M 13/11; H04L 1/00**

(86) International application number:
**PCT/CN2020/102814**

(87) International publication number:
**WO 2021/027488 (18.02.2021 Gazette 2021/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.08.2019 CN 201910754120**

(71) Applicant: **ZTE Corporation**
**Shenzhen, Guangdong 518057 (CN)**

(72) Inventors:
- **CHEN, Yueqiang**
  **Shenzhen, Guangdong 518057 (CN)**
- **ZHANG, Caihong**
  **Shenzhen, Guangdong 518057 (CN)**

(74) Representative: **WBH Wachenhausen Patentanwälte PartG mbB**
**Müllerstraße 40**
**80469 München (DE)**

(54) **LDPC CODING METHOD AND APPARATUS, AND BASE STATION AND READABLE STORAGE MEDIUM**

(57) An LDPC coding method and apparatus, and a base station and a readable storage medium. The method comprises: acquiring coded original data and an expansion factor, and segmenting the coded original data according to the expansion factor to obtain segmented coded data (S1), and determining a shift value according to the expansion factor, and generating check information on the basis of the shift value and the segmented coded data in order to complete coding (S3).

Acquire coded original data and an expansion factor, and segment the coded original data according to the expansion factor to obtain segmented coded data
S1
Store the segmented coded data
S2
Determine a shift value according to the expansion factor, and generate check information on the basis of the shift value and the segmented coded data to complete coding
S3

FIG. 1

EP 4 016 849 A1

## Description

### CROSS-REFERENCE TO RELATED APPLICATION

The present application is on the basis of the Chinese Patent Application 201910754120.3 filed on August 15, 2019, and claims priority of the Chinese patent application, the entire contents of which are incorporated herein by reference.

### TECHNICAL FIELD

The present invention relates to the technical field of communications, and in particular to an LDPC coding method and apparatus, a base station and a computer-readable storage medium.

### BACKGROUND

As an important part in wireless communication systems, channel coding, together with the multiple access technology and the multi-input multi-output technology, constitutes three key technologies in the 5G air interface.

Since the release of the Shannon formula, there have been many error correction coding methods, which are classified into two categories, i.e., block codes and trellis codes. Due to the limitation of the number of states, trellis codes, together with conventional block codes, are suitable for short codes. For the both, the decoding complexity is exponentially related to the code length.

Turbo codes currently used in 4G belong to long codes with coding performance approaching the Shannon limit. Turbo codes adopt a parallel cascade recursive structure, and their component codes use systematic convolutional codes. Interleaving is introduced between encoders to reduce the correlation of information between encodes and simulate the random coding form. During decoding, the Soft-in-Soft-out decoding algorithm and the information feedback decoding form are adopted, making Turbo codes more approaching the Shannon limit. Turbo codes have the disadvantage of high decoding complexity. In addition, when code blocks are large in length, the interleaver has a too high delay.

With the advent of 5G technology, the 3GPP determines that the 5G communication adopts a coding scheme using LDPC codes as long codes. As a kind of linear block codes with sparse check matrices, LDPC codes not only have good performance approaching the Shannon limit, but also are low in coding complexity and flexible in structure.

Different LDPC coding structures have a great impact on throughput, and are obviously different in hardware resource consumption.

### SUMMARY

Embodiments of the present invention provide an LDPC coding method and apparatus, a base station and a computer-readable storage medium, to at least solve the problems of high LDPC coding delay and high resource consumption in some situations to a certain extent.

According to an aspect of the present invention, an embodiment of the present invention provides an LDPC coding method. The method may include: acquiring coded original data and an expansion factor, and segmenting the coded original data according to the expansion factor to obtain segmented coded data; and, determining a shift value according to the expansion factor, and generating check information on the basis of the shift value and the segmented coded data to complete coding.

According to another aspect of the present invention, an embodiment of the present invention provides an LDPC coding apparatus. The apparatus may include a data processing module and a check information generation module. The data processing module is configured to acquire coded original data and an expansion factor, segment the coded original data according to the expansion factor to obtain segmented coded data, and determine a shift value according to the expansion factor. The check information generation module is configured to generate check information on the basis of the shift value and the segmented coded data to complete coding.

According to yet another aspect of the present invention, an embodiment of the present invention provides a computer-readable storage medium having stored thereon programs for realizing information transmission. The programs, when executed by a processor, cause the processor to carry out the coding method described above.

According to yet another aspect of the present invention, an embodiment of the present invention provides a base station. The base station may include a memory, a processor and computer programs stored on the memory and executable by the processor. The computer programs, when executed by the processor, cause the processor to carry out the coding method above-mentioned.

The foregoing description merely shows the summary of the technical schemes of the present invention. In order to make the technical means of the present application more clearly, the technical means may be implemented in accordance with the contents in this description and, in order to make the above and other objectives, features and advantages of the present application more obvious, the implementations of the present application will be illustrated hereinafter.

### BRIEF DESCRIPTION OF DRAWINGS

Various other advantages and benefits will become apparent to a person having ordinary skills in the art by reading the following detailed description of the preferred implementations. The drawings are only for illustrating the preferred embodiments, rather than limiting the present invention. In addition, throughout the drawings, like reference numerals represent like components, in which:

FIG. 1 is a flowchart according to a first embodiment of the present invention;
FIG. 2 is a flowchart of obtaining segmented coded data according to the first embodiment of the present invention;
FIG. 3 is a schematic structural diagram of an apparatus according to a second embodiment of the present invention;
FIG. 4 is a schematic diagram of data processing in the apparatus according to the second embodiment of the present invention;
FIG. 5 is a basic matrix of an expansion factor 512 according to a third embodiment of the present invention;
FIG. 6 is a pre-shifted basic matrix of the expansion factor 512 according to the third embodiment of the present invention;
FIG. 7 is a basic matrix of an expansion factor 256 according to a fourth embodiment of the present invention;
FIG. 8 is a pre-shifted basic matrix of the expansion factor 256 according to the fourth embodiment of the present invention; and
FIG. 9 is a schematic structure diagram of a base station according to a sixth embodiment of the present invention.

## DETAILED DESCRIPTION

The exemplary embodiments of the present invention will be described in more detail below with reference to the drawings. Although the exemplary embodiments of the present invention are shown in the drawings, it should be understood that the present invention can be implemented in various forms and should not be limited by the embodiments described herein. Rather, these embodiments are provided for a more thorough understanding of the present invention and conveying the scope of the present invention to those having ordinary skills in the art.

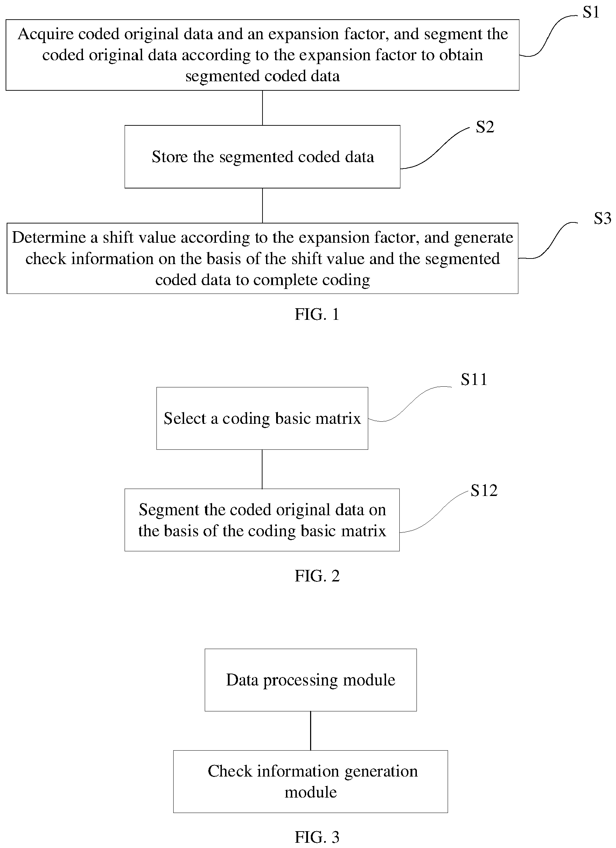

In a first aspect, a first embodiment of the present invention provides an LDPC coding method. As shown in FIG. 1, the method includes steps S1 to S3.

At S1, coded original data and an expansion factor are acquired, and the coded original data is segmented according to the expansion factor to obtain segmented coded data.

At S2, the segmented coded data is stored.

At S3, a shift value is determined according to the expansion factor, and check information is generated on the basis of the shift value and the segmented coded data to complete coding.

In the embodiment of the present invention, by segmenting the coded original data according to the expansion factor to obtain segmented coded data, determining a shift value according to the expansion factor and generating check information on the basis of the shift value and the segmented coded data to complete coding, the dependency between various check information during the coding process is broken, and the problems of high coding delay and high resource consumption in the existing technology are thus solved.

In an embodiment of the present invention, as shown in FIG. 2, the segmenting the coded original data according to the expansion factor to obtain segmented coded data includes steps S11 and S12.

At S11, a coding basic matrix is selected according to the length of the coded original data and the expansion factor.

At S12, the coded original data is segmented according to the expansion factor to obtain segmented coded data.

In an embodiment, the coding basic matrix in the embodiment is divided into left and right parts, where the left part shows a non-check matrix and the left part shows a check matrix. In the embodiment, there is a correspondence between the basic matrix and the coded original data. For example, in a case where the coded original data is $Z\times8$ (where Z is the expansion factor), the coding basic matrix may be selected as $18\times26$, where the non-check matrix is $18\times8$ and the check matrix is $18\times18$.

With the above technical schemes, by shifting the selected coding basic matrix, the dependency between various check information during the coding process can be broken, and a reasonable layout of the coding structure can be realized, thereby improving the coding efficiency.

In an embodiment of the present invention, after the coded original data is segmented according to the expansion factor to obtain segmented coded data, the method further includes the following step.

At S2, the segmented coded data is stored.

The segmented coded data is stored for facilitating the scheduling of the data during a subsequent processing.

In an embodiment of the present invention, the determining a shift value according to the expansion factor includes:
calculating, according to a check formula for generating check information in the basic matrix, a shift value of the coding basic matrix corresponding to the expansion factor.

In an embodiment, the shift value of the check matrix in the coding basic matrix corresponding to the expansion factor is calculated according to the check formula for generating check information in the basic matrix. The method is to calculate cyclic shift information (i.e., the shift value) of each element according to the check formula for generating check information in the check matrix by adopting the basic matrix as a prototype, and then generate coding control information on this basis.

Thus, the shift value corresponding to each element in the basic matrix is obtained. It is also possible to calculate a pre-shifted basic matrix according to the shift value corresponding to the basic matrix.

In yet another embodiment of the present invention, after the shift value is determined according to the expansion factor, the method further includes: determining a coding intermediate value according to the coded original data, the coding basic matrix and the shift value.

In the embodiment, a modulo-2 addition operation may be performed on the coded original data according to the non-check matrix on the left of the coding basic matrix, to obtain a coding intermediate value. Specifically, it is possible that a pre-shifted basic matrix is obtained through calculation according to the shift value by utilizing the coding basic matrix, and a modulo-2 addition operation is performed on the coded original data by utilizing the pre-shifted basic matrix to obtain a coding intermediate value. After the coding intermediate value is obtained, in the embodiment, the coding intermediate value can be stored.

The generating check information on the basis of the shift value and the segmented coded data includes: generating check information according to the coding intermediate value starting from the shift value.

In an embodiment, after the coding intermediate value is obtained, on the basis of taking the shift value as a starting position, the check information is generated according to the coding intermediate value.

Compared with some situations, with the method according to the first embodiment of the present invention, the dependency between various check information during the coding process is broken, and a reasonable layout of the coding structure is realized, so that the coding delay in the whole physical layer link is shortened by a parallel mechanism. Meanwhile, by this parallel mechanism, the throughput of the whole system is improved, so that coding is no longer the bottleneck of improving the throughput of the system, and the problems and defects of high LDPC coding delay, high resource consumption and high hardware cost in some cases are overcome.

In a second aspect, a second embodiment of the present invention provides an LDPC coding apparatus. As shown in FIG. 3, the apparatus may include a data processing module and a check information generation module.

The data processing module is configured to acquire coded original data and an expansion factor, segment the coded original data according to the expansion factor to obtain segmented coded data, and determine a shift value according to the expansion factor.

The check information generation module is configured to generate check information on the basis of the shift value and the segmented coded data to complete coding.

In the embodiment of the present invention, the data processing module segments the coded original data according to the expansion factor to obtain segmented coded data and determines a shift value according to the expansion factor, and the check information generation module generates check information on the basis of the shift value and the segmented coded data to complete coding. Thus, the dependency between various check information during the coding process is broken, and the problem that automatic correction cannot be realized due to the solidification of the compensation value in some cases is solved.

In an embodiment of the present invention, the data processing module is configured to select a coding basic matrix according to the length of the coded original data and the expansion factor.

The data processing module is configured to segment the coded original data according to the expansion factor to obtain segmented coded data.

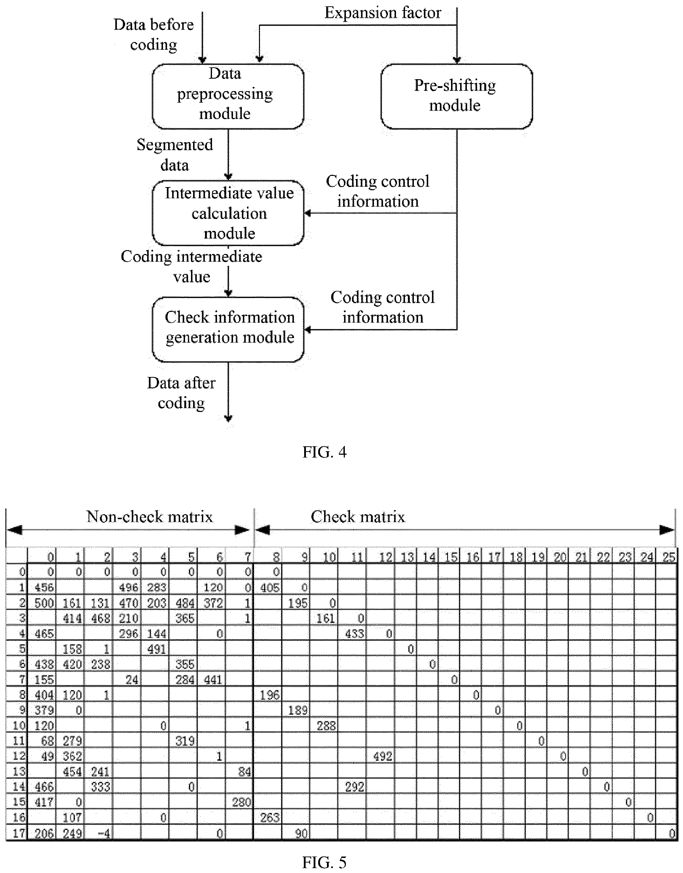

As shown in FIG. 4, in the embodiment, the data processing module includes a data preprocessing module and a pre-shifting module.

The data preprocessing module is configured to select a coding basic matrix according to the length of the coded original data and the expansion factor, i.e., selecting a coding basic matrix according to an original length of the data before coding and the expansion factor, and segments the coded original data according to the coding basic matrix to obtain segmented coded data, as shown in FIG. 4. With reference to FIG. 4, the data preprocessing module outputs the segmented data.

The coding basic matrix in the embodiment is divided into left and right parts, where the left part shows a non-check matrix and the left part shows a check matrix. In the embodiment, a correspondence exists between the basic matrix and the coded original data. For example, in a case where the coded original data is $Z \times 8$ (where Z is the expansion factor), the coding basic matrix can be selected as $18 \times 26$, where the non-check matrix is $18 \times 8$ and the check matrix is $18 \times 18$.

According to the above technical schemes, the data preprocessing module selects a coding basic matrix, so that the dependency between various check information during the coding process can be broken, and a reasonable layout of the coding structure can be realized, leading to an improved coding efficiency.

In an embodiment of the present invention, the data processing module is configured to calculate, according to a check formula for generating check information in the basic matrix, a shift value of the coding basic matrix corresponding to the expansion factor.

The data processing module calculates, according to the check formula for generating check information in the basic matrix, a shift value of the check matrix in the coding basic matrix corresponding to the expansion factor. The pre-shifting module of the data processing module can calculate, in an order of generating check information in the check matrix, a corresponding check information index (i.e., shift value) of shifting jump by taking the basic matrix as a prototype, and then generate coding control information on this basis. Thus, the shift value corresponding to each element in the basic matrix is obtained by the pre-shifting module. A pre-shifted basic matrix may also be obtained through calculation according to the shift value corresponding to the basic matrix.

The data processing module is further configured to determine a coding intermediate value according to the coded original data and the coding basic matrix.

With reference to FIG. 4, the data processing module may further include an intermediate value calculation module. In the embodiment, the intermediate value calculation module may perform a modolo-2 addition operation on the coded original data according to the non-check matrix on the left of the coding basic matrix. In an embodiment, a modulo-2 addition operation may be performed on the coded original data according to the pre-shifted basic matrix obtained by the pre-shifting module to obtain a coding intermediate value. Thus, the coding intermediate value can be obtained.

The check information generation module is configured to generate check information according to the coding intermediate value starting from the shift value.

In an embodiment, after the coding intermediate value is obtained, the check information generation module generates check information according to the coding intermediate value on the basis of taking the shift value as a starting position.

In an embodiment of the present invention, the apparatus further includes a storage module.

The storage module is configured to store the segmented coded data and store the coding intermediate value after obtaining the coding intermediate value.

Compared with some situations, by adopting the apparatus according to the second embodiment of the present invention, the dependency between various check information during the coding process is broken, and a reasonable layout of the coding structure is realized, so that the coding delay in the whole physical layer link is shortened by a parallel mechanism. Meanwhile, by this parallel mechanism, the throughput of the whole system is improved, so that coding is no longer the bottleneck of improving the throughput of the system, and the problems and defects of high LDPC coding delay, high resource consumption and high hardware cost in some cases are overcome.

In a third aspect, on the basis of the first embodiment, a third embodiment of the present invention provides an implementation instance of the LDPC coding method. In the embodiment, the process of coding the coded original data by the LDPC coding module upon receiving data and selecting the basic matrix of FIG. 5 is described. The process may include steps S101 to S108.

At S101, coded original data is received as a $Z\times8$ matrix, and a basic matrix shown in FIG. 5 is selected. In the $18\times26$ basic matrix, an $18\times8$ non-check matrix and an $18\times8$ check matrix $18\times18$ present.

At S102, a code block segmentation operation is performed on the coded original data according to an expansion factor Z=512. Each piece of data to be coded is recorded as C, where C is $512\times8$. The non-check matrix has 18 rows and 8 columns, so the original coded data is divided into 8 parts for storage, which are recorded as [C0, C1, C2, C3, C4, C5, C6, C7]. Each piece of data is $512\times1$, and an index value is equal to 0.

At S103, in the 0th row of the basic matrix in FIG. 5, the check information is a result output from the 0th row and the 8th column. Eight elements in the 0th row of the non-check matrix are all 0, indicating that shifting is not performed. A multiply-add operation is performed on [C0, C1, C2, C3, C4, C5, C6, C7] and eight elements in the 0th row of the non-check matrix, and the result is recorded as M0, where M0+V0=0, and the shift value is 0, so that V0 is directly obtained.V0 is the check information of the result of coding in the 0th row.

At S104, in a first row of the basic matrix of FIG. 5, a multiply-add operation is performed on [C0, C1, C2, C3, C4, C5, C6, C7] and eight elements in the first row of the non-check matrix, and the result is recorded as M1. M1+V0'+V1=0, where V0' is the result of shifting V0 for 405 times and V1 is the check information of the result of coding in the first row.

Here, M1+V0'+V1=0 is converted into $M1^{107}+V0^{0}+V1^{107}=0$ according to the basic matrix of FIG. 5, and the shift value is 107. The 107th element in M1 and the 0th element in V0 are taken to obtain the value of the 107th element in V1, and the value is directly stored to a 107 storage space corresponding to the coding check information V1.

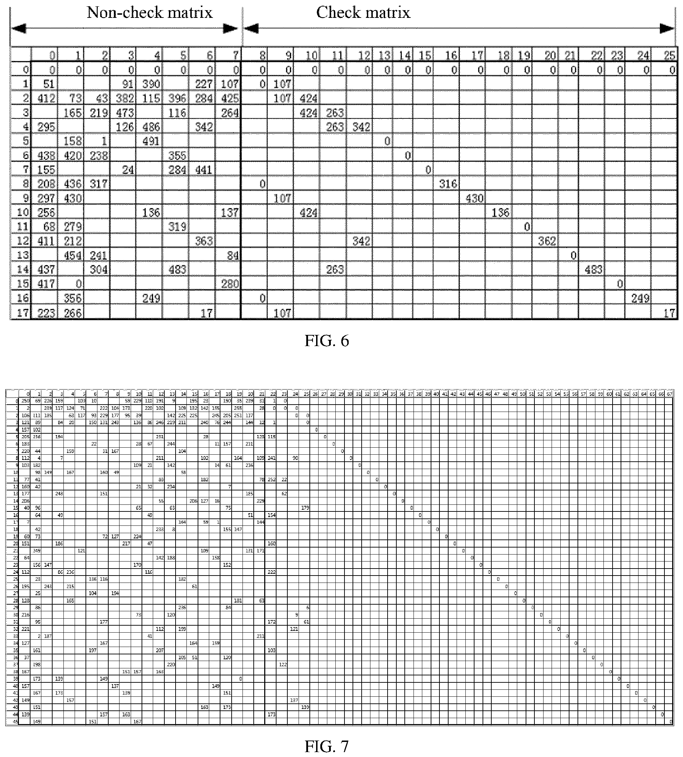

FIG. 6 is obtained from FIG. 5 after processing, and the original data is processed according to FIG. 6 to obtain an intermediate value. The value of $M1^{107}$ is obtained by the following method: a first non-check matrix in the pre-shifting matrix of FIG. 6 is [51, -1, -1, 91, 390, -1, 277, 107], indicating that C0 is shifted for 51 times to participate in operation, C3 is shifted for 91 times, C4 is shifted for 390 times, C6 is shifted for 277 times, C7 is shifted for 107 times, and -1 in blank indicates no participation in operation. Thus, the M1 element obtained for the first time is $M1^{107}$.

At S105, in a second row of the basic matrix of FIG. 5, a multiply-add operation is performed on [C0, C1, C2, C3, C4, C5, C6, C7] and eight elements in the second row of the non-check matrix, and the result is recorded as M2. M2+V1'+V2=0, where V1' is the result of shifting V1 for 195 times and V2 is the check information of the result of coding in the second row.

Here, M2+V1'+V2=0 is converted into $M2^{424}+V1^{107}+V2^{424}=0$ according to the basic matrix of FIG. 5, and the shift value is 424. The 424th element in M2 and the $V1^{107}$ in step S104 are taken to obtain the value of the 424th element in V2, and the value is directly stored to a 424 storage space corresponding to the coding check information V2.

The value of $M2^{424}$ is obtained by the following method: a second non-check matrix in the pre-shifting matrix of FIG. 6 is [412, 73, 43, 382, 115, 396, 284, 425], indicating that C0 is shifted for 412 times to participate in operation, C1 is shifted for 73 times, C2 is shifted for 73 times, C3 is shifted for 382 times, C4 is shifted for 115 times, C5 is shifted for 396 times and C7 is shifted for 425 times. Thus, the M2 element obtained for the first time is $M2^{424}$.

At S106, in a third row of the basic matrix of FIG. 5, a multiply-add operation is performed on [C0, C1, C2, C3, C4, C5, C6, C7] and eight elements in the third row of the non-check matrix, and the result is recorded as M3. M3+V2'+V3=0, where V2' is the result of shifting V2 for 161 times and V3 is the check information of the result of coding in the third row.

Here, M3+V2'+V3=0 is converted into $M3^{263}+V2^{424}+V3^{263}=0$ according to the basic matrix of FIG. 5, and the shift value is 263. The 263$^{th}$ element in M3 and the $V2^{424}$ in step S105 are taken to obtain the value of the 263$^{th}$ element in V3, and the value is directly stored to a 263 storage space corresponding to the coding check information V2.

The value of $M3^{263}$ is obtained by the following method: the second non-check matrix in the pre-shifting matrix of FIG. 6 is [-1, 165, 219, 473, -1, 116, -1, 264], indicating that C0 is not shifted, C1 is shifted for 165 times, C2 is shifted for 219 times, C3 is shifted for 473 times, C4 is not shifted, C5 is shifted for 116 times, C6 is not shifted and C7 is shifted for 264 times. Thus, the M3 element obtained for the first time is $M3^{263}$.

At S107, by analogy, in a 17$^{th}$ row of the basic matrix of FIG. 5, a multiply-add operation is performed on [C0, C1, C2, C3, C4, C5, C6, C7] and eight elements in the 17$^{th}$ row of the non-check matrix, and the result is recorded as M7. M17+V1'+V17=0, where V1' is the result of shifting V1 for 90 times and V17 is the check information of the result of coding in the 17$^{th}$ row.

Here, M17+V1'+V17=0 is converted into $M17^{17}+V1^{107}+V17^{17}=0$ according to the basic matrix of FIG. 5, and the shift value is 17. The 17$^{th}$ element in M17 and the $V1^{107}$ in step S104 are taken to obtain the value of the 17$^{th}$ element in V17, and the value is directly stored to a 17 storage space corresponding to the coding check information V17.

The value of $M17^{17}$ is obtained by the following method: the 17$^{th}$ non-check matrix in the pre-shifting matrix of FIG. 6 is [233, 266, -1, -1, -1, -1, -1, 17, -1], indicating that C0 is shifted for 233 times, C1 is shifted for 266 times, C6 is shifted for 17 times, and C2, C3, C4, C5 and C7 are not shifted. Thus, the M17 element obtained for the first time is $M17^{17}$, and the index value is added by 1.

At S108, S103 to S107 are repeated until the index value is equal to the expansion factor 512, indicating the coding is completed. The output results of coding are M0, V0, V1, V2, V3, V4, V5, V6, V7, V8, V9, V10, V11, V12, V13, V14, V15, V16 and V17.

In a fourth aspect, on the basis of the first embodiment, a fourth embodiment of the present invention provides an implementation instance of the LDPC coding method. In the embodiment, the process of coding the coded original data by the LDPC coding module upon receiving data and selecting the basic matrix of FIG. 7 is described The process may include steps S201 to S208.

At S201, coded original data is received as a Z×22 matrix, and a basic matrix shown in FIG. 7 is selected. In the 46×68 basic matrix, a 46×22non-check matrix and a 46×46 check matrix present.

At S202, a code block segmentation operation is performed on the coded original data according to an expansion factor Z=256. Each piece of data to be coded is recorded as C, where C is 256×22. The non-check matrix has 46 rows and 22 columns, so the original coded data is divided into 22 parts for storage, which are recorded as [C0, C1, C2, C3, C4, C5, C6, C7, C8, C9, C10, C11, C12, C13, C14, C15, C16, C17, C18, C19, C20, C21]. Each piece of data is 256×1, and an index value is equal to 0.

At S203, in the 0$^{th}$ to third rows of the basic matrix of FIG. 7,

a multiply-add operation is performed on [C0, C1, C2, C3, C4, C5, C6, C7, C8, C9, C10, C11, C12, C13, C14, C15, C16, C17, C18, C19, C20, C21] and 22 elements in the 0$^{th}$ row of the non-check matrix, and the result is recorded as M0. M0+V0'+V1=0, where V0' is the result of shifting V0 for 1 time and V1 is the check information of the result of coding in the first row.

A multiply-add operation is performed on [C0, C1, C2, C3, C4, C5, C6, C7, C8, C9, C10, C11, C12, C13, C14, C15, C16, C17, C18, C19, C20, C21] and 22 elements in a first row of the non-check matrix, and the result is recorded as M1. M1+V0+V1+V2=0, where V0 and V2 are the check information of the results of coding in the 0$^{th}$ row and 2$^{nd}$ row, respectively.

A multiply-add operation is performed on [C0, C1, C2, C3, C4, C5, C6, C7, C8, C9, C10, C11, C12, C13, C14, C15, C16, C17, C18, C19, C20, C21] and 22 elements in the 2$^{nd}$ row of the non-check matrix, and the result is recorded as M2. M2+V2+V3=0, where V3 is the check information of the result of coding in the 3$^{rd}$ row.

A multiply-add operation is performed on [C0, C1, C2, C3, C4, C5, C6, C7, C8, C9, C10, C11, C12, C13, C14, C15, C16, C17, C18, C19, C20, C21] and 22 elements in the 3$^{rd}$ row of the non-check matrix, and the result is recorded as M3. M3+V0'+V3=0, where V0' is the result of shifting V0 for 1 time.

$$M0+V0'+V1=0$$

$$M1+V0+V1+V2=0$$

$$M2+V2+V3=0$$

$$M3+V0'+V3=0$$

The $0^{th}$ to $3^{rd}$ rows of the basic matrix are jointly operated to obtain V0, V1, V2 and V3.

At S204, in a $4^{th}$ row of the basic matrix of FIG. 7, a multiply-add operation is performed on [C0, C1, C2, C3, C4, C5, C6, C7, C8, C9, C10, C11, C12, C13, C14, C15, C16, C17, C18, C19, C20, C21] and 22 elements in the $4^{th}$ row of the non-check matrix, and the result is recorded as M4. M4+V4=0, where V4 is the check information of the result of coding in the $4^{th}$ row.

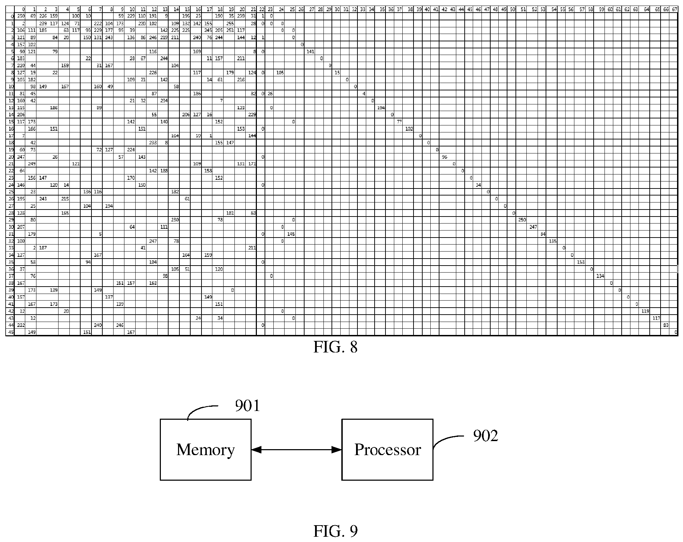

The value of M4 is obtained by the following method: a $4^{th}$ non-check matrix in the pre-shifting matrix of FIG. 8 is [157, 102, -1, -1, -1, -1, -1, -1, -1, -1, -1, -1, -1, -1, -1, -1, -1, -1, -1, -1, -1, -1], indicating that C0 is shifted for 157 times, C1 is shifted for 102 times, and the remaining is not shifted. Thus, the M4 element obtained for the first time is $M4^0$.

At S205, in a $5^{th}$ row of the basic matrix of FIG. 7, a multiply-add operation is performed on [C0, C1, C2, C3, C4, C5, C6, C7, C8, C9, C10, C11, C12, C13, C14, C15, C16, C17, C18, C19, C20, C21] and 22 elements in the $5^{th}$ row of the non-check matrix, and the result is recorded as M5. M5+V0'+V5=0, where V0' is the result of shifting V0 for 115 times, and V5 is the check information of the result of coding in the $5^{th}$ row.

M5+V0'+V5=0 is converted into $M5^{141}+V0^0+V5^{141}=0$ according to the basic matrix of FIG. 7, and the shift value is 141. The $141^{th}$ element in M5 and the $V0^0$ in step S202 are taken to obtain the value of the $141^{th}$ element in V5, and the value is directly stored to a 141 storage space corresponding to the coding check information 5.

The value of $M5^{141}$ is obtained by the following method: a $5^{th}$ non-check matrix in the pre-shifting matrix of FIG. 8 is [90, 121, -1, 79, -1, -1, -1, -1, -1, -1, -1, -1, 116, -1, -1, -1, 169, -1, -1, -1, -1, 8], indicating that C0 is shifted for 90 times, C1 is shifted for 121 times, C3 is shifted for 79 times, C12 is shifted for 116 times, C16 is shifted for 169 times, C21 is shifted for 8 times, and the remaining is not shifted. Thus, the M5 element obtained for the first time is $M5^{141}$.

At S206, in a $6^{th}$ row of the basic matrix of FIG. 7, a multiply-add operation is performed on [C0, C1, C2, C3, C4, C5, C6, C7, C8, C9, C10, C11, C12, C13, C14, C15, C16, C17, C18, C19, C20, C21] and 22 elements in the $6^{th}$ row of the non-check matrix, and the result is recorded as M6. M6+V6=0, where V6 is the check information of the result of coding in the $6^{th}$ row.

The value of M6 is obtained by the following method: a $6^{th}$ non-check matrix in the pre-shifting matrix of FIG. 8 is [183, -1, -1, -1, -1, -1, 22, -1, -1, -1, 28, 67, -1, 244, -1, -1, -1, 11, 157, -1, 211, -1], indicating that C0 is shifted for 183 times, C6 is shifted for 22 times, C10 is shifted for 28 times, C11 is shifted for 67 times, C13 is shifted for 244 times, C17 is shifted for 11 times, C18 is shifted for 157 times, C20 is shifted for 211 times, and the remaining is not shifted. Thus, the M6 element obtained for the first time is $M6^0$.

At S207, by that analogy, in a $45^{th}$ row of the basic matrix of FIG .7,
a multiply-add operation is performed on [C0, C1, C2, C3, C4, C5, C6, C7, C8, C9, C10, C11, C12, C13, C14, C15, C16, C17, C18, C19, C20, C21] and 22 elements in the $45^{th}$ row of the non-check matrix, and the result is recorded as M45. M45+V45=0, where V45 is the check information of the result of coding in the $45^{th}$ row.

The value of M45 is obtained by the following method: a $45^{th}$ non-check matrix in the pre-shifting matrix of FIG. 8 is [-1, 149, -1, -1, -1, -1, 151, -1, -1, -1, 167, -1, -1, -1, -1, -1, -1, -1, -1, -1, -1, -1], indicating that C1 is shifted for 149 times, C6 is shifted for 151 times, C10 is shifted for 167 times, and the remaining is not shifted. Thus, the M45 element obtained for the first time is $M45^0$, and the index value is added by 1.

At S208, S202 to S207 are repeated until the index value is equal to the code block expansion factor 256, indicating that the coding is completed. The output results of coding are M0, V0, V1, V2, ... , V15.

In a fifth aspect, a fifth embodiment of the present invention provides a computer-readable storage medium storing programs for realizing information transmission. The programs, when executed by a processor, cause the processor to carry out the coding method according to the first embodiment.

In a sixth aspect, with reference to FIG. 9, a sixth embodiment of the present invention provides a base station. The base station may include a memory 901, a processor 902 and computer programs that are stored on the memory and executable by the processor. The computer programs, when executed by the processor, cause the processor to carry out the coding method according to the first embodiment.

In the embodiments of the present invention, by segmenting the coded original data according to the expansion factor to obtain segmented coded data, determining a shift value according to the expansion factor and generating check information on the basis of the shift value and the segmented coded data to complete coding, the problems of high coding delay and high resource consumption in some cases are solved, and positive technical effects are achieved.

It is to be noted that, as used herein, the term "comprise/comprising", "include/including" or any other variant thereof is non-exclusive, so that a process, method, object or device including a series of elements not only includes these elements, but also includes other elements not listed clearly, or further includes inherent elements of this process, method, object or device. Without more restrictions, the element defined by the statement "comprising an/a..." does not exclude other identical elements in the process, method, object or device including this element.

The serial numbers in the embodiments of the present invention are merely for description and does not indicate the superiority of the embodiments.

From the above description of the implementations, those having ordinary skills in the art can clearly understand that the embodiment methods may be implemented by software and necessary general-purpose hardware platforms. Of course, the method embodiments may also be implemented by hardware. However, in many cases, the former is preferred. Based on this understanding, the technical schemes of the present invention may be essentially embodied in the form of software products, or some of the technical schemes that contribute to the existing technology may be embodied in the form of software products. The computer software products are stored in a storage medium (e.g., ROM/RAM, magnetic disks or optional disks), and include a number of instructions to enable a terminal (which may be a mobile terminal, a computer, a server, an air conditioner, a network device, etc.) to execute the methods according to various embodiments of the present invention.

Although the embodiments of the present invention have been described above with reference to the drawings, the present invention is not limited to the above implementations. The above implementations are merely illustrative but not limiting. A person having ordinary skills in the art may make various forms under the teaching of the present invention without departing from the idea of the present invention and the protection scope of the appended claims, and these forms shall fall into the protection scope of the present invention.

## Claims

**1.** An LDPC coding method, comprising steps of:

acquiring coded original data and an expansion factor, and segmenting the coded original data according to the expansion factor to obtain segmented coded data; and
determining a shift value according to the expansion factor, and generating check information on the basis of the shift value and the segmented coded data to complete coding.

**2.** The method of claim 1, after acquiring coded original data and an expansion factor, further comprising:
selecting a coding basic matrix according to a length of the coded original data and the expansion factor.

**3.** The method of claim 1, after segmenting the coded original data according to the expansion factor to obtain segmented coded data, further comprising:
storing the segmented coded data.

**4.** The method of claim 2, wherein the determining a shift value according to the expansion factor comprises:

calculating, according to a check formula for generating check information in the basic matrix, a shift value of the coding basic matrix corresponding to the expansion factor.

**5.** The method of claim 2, after determining a shift value according to the expansion factor, further comprising:

determining a coding intermediate value according to the coded original data, the coding basic matrix and the shift value; and
the generating check information on the basis of the shift value and the segmented coded data comprises:
generating check information according to the coding intermediate value starting from the shift value.

**6.** An LDPC coding apparatus, comprising:

a data processing module, configured to acquire coded original data and an expansion factor, segment the coded original data according to the expansion factor to obtain segmented coded data and determine a shift value according to the expansion factor; and
a check information generation module, configured to generate check information on the basis of the shift value and the segmented coded data to complete coding.

**7.** The apparatus of claim 6, wherein,
the data processing module is configured to select a coding basic matrix according to the length of the coded original data and the expansion factor.

**8.** The apparatus of claim 6, further comprising:
a storage module, configured to store the segmented coded data.

**9.** The apparatus of claim 7, wherein the data processing module is configured to calculate, according to a check formula for generating check information in the basic matrix, the shift value of the coding basic matrix corresponding to the expansion factor.

**10.** The apparatus of claim 7, wherein the data processing module is further configured to determine a coding intermediate value according to the coded original data, the coding basic matrix and the shift value; and
the check information generation module is configured to generate check information according to the coding intermediate value starting from the shift value.

**11.** A computer-readable storage medium having stored thereon programs for realizing information transmission which, when executed by a processor, cause the processor to carry out the coding method of any one of claims 1 to 5.

12. A base station, comprising: a memory, a processor and computer programs that are stored on the memory and executable by the processor, wherein the computer programs, when executed by the processor, cause the processor to carry out the coding method of any one of claims 1 to 5.

Acquire coded original data and an expansion factor, and segment the coded original data according to the expansion factor to obtain segmented coded data
S1
Store the segmented coded data
S2
Determine a shift value according to the expansion factor, and generate check information on the basis of the shift value and the segmented coded data to complete coding
S3

FIG. 1

Select a coding basic matrix
S11
Segment the coded original data on the basis of the coding basic matrix
S12

FIG. 2

Data processing module
Check information generation module

FIG. 3

Data before coding
Expansion factor
Data preprocessing module
Pre-shifting module
Segmented data
Intermediate value calculation module
Coding control information
Coding intermediate value
Check information generation module
Coding control information
Data after coding

FIG. 4

| | Non-check matrix | | | | | | | | Check matrix | | | | | | | | | | | | | | | | | |
|---|---|---|---|---|---|---|---|---|---|---|---|---|---|---|---|---|---|---|---|---|---|---|---|---|---|---|
| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 |
| 0 | 0 | 0 | 0 | 0 | 0 | 0 | 0 | 0 | 0 | | | | | | | | | | | | | | | | | |
| 1 | 456 | | | 496 | 283 | | 120 | 0 | 405 | 0 | | | | | | | | | | | | | | | | |
| 2 | 500 | 161 | 131 | 470 | 203 | 484 | 372 | 1 | | 195 | 0 | | | | | | | | | | | | | | | |
| 3 | | 414 | 468 | 210 | | 365 | | 1 | | | 161 | 0 | | | | | | | | | | | | | | |
| 4 | 465 | | | 296 | 144 | | 0 | | | | | 433 | 0 | | | | | | | | | | | | | |
| 5 | | 158 | 1 | | 491 | | | | | | | | | 0 | | | | | | | | | | | | |
| 6 | 438 | 420 | 238 | | | 355 | | | | | | | | | 0 | | | | | | | | | | | |
| 7 | 155 | | | 24 | | 284 | 441 | | | | | | | | | 0 | | | | | | | | | | |
| 8 | 404 | 120 | 1 | | | | | | 196 | | | | | | | | 0 | | | | | | | | | |
| 9 | 379 | 0 | | | | | | | | 189 | | | | | | | | 0 | | | | | | | | |
| 10 | 120 | | | | 0 | | | 1 | | | 288 | | | | | | | | 0 | | | | | | | |
| 11 | 68 | 279 | | | | 319 | | | | | | | | | | | | | | 0 | | | | | | |
| 12 | 49 | 362 | | | | | 1 | | | | | | 492 | | | | | | | | 0 | | | | | |
| 13 | | 454 | 241 | | | | | 84 | | | | | | | | | | | | | | 0 | | | | |
| 14 | 466 | | 333 | | | 0 | | | | | | 292 | | | | | | | | | | | 0 | | | |
| 15 | 417 | 0 | | | | | | 280 | | | | | | | | | | | | | | | | 0 | | |
| 16 | | 107 | | | 0 | | | | 263 | | | | | | | | | | | | | | | | 0 | |
| 17 | 206 | 249 | -4 | | | | 0 | | | 90 | | | | | | | | | | | | | | | | 0 |

FIG. 5

| | Non-check matrix | | | | | | | | Check matrix | | | | | | | | | | | | | | | | | |
|---|---|---|---|---|---|---|---|---|---|---|---|---|---|---|---|---|---|---|---|---|---|---|---|---|---|---|
| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 |
| 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 |
| 1 | 51 | | | 91 | 390 | | 227 | 107 | 0 | 107 | | | | | | | | | | | | | | | | |
| 2 | 412 | 73 | 43 | 382 | 115 | 396 | 284 | 425 | | 107 | 424 | | | | | | | | | | | | | | | |
| 3 | | 165 | 219 | 473 | | 116 | | 264 | | | 424 | 263 | | | | | | | | | | | | | | |
| 4 | 295 | | | 126 | 486 | | 342 | | | | | 263 | 342 | | | | | | | | | | | | | |
| 5 | | 158 | 1 | | 491 | | | | | | | | | 0 | | | | | | | | | | | | |
| 6 | 438 | 420 | 238 | | | 355 | | | | | | | | | 0 | | | | | | | | | | | |
| 7 | 155 | | | 24 | | 284 | 441 | | | | | | | | | 0 | | | | | | | | | | |
| 8 | 208 | 436 | 317 | | | | | | 0 | | | | | | | | 316 | | | | | | | | | |
| 9 | 297 | 430 | | | | | | | | 107 | | | | | | | | 430 | | | | | | | | |
| 10 | 256 | | | | 136 | | | 137 | | | 424 | | | | | | | | 136 | | | | | | | |
| 11 | 68 | 279 | | | | 319 | | | | | | | | | | | | | | 0 | | | | | | |
| 12 | 411 | 212 | | | | | 363 | | | | | | 342 | | | | | | | | 362 | | | | | |
| 13 | | 454 | 241 | | | | | 84 | | | | | | | | | | | | | | 0 | | | | |
| 14 | 437 | | 304 | | | 483 | | | | | | 263 | | | | | | | | | | | 483 | | | |
| 15 | 417 | 0 | | | | | | 280 | | | | | | | | | | | | | | | | 0 | | |
| 16 | | 356 | | | 249 | | | | 0 | | | | | | | | | | | | | | | | 249 | |
| 17 | 223 | 266 | | | | | 17 | | | 107 | | | | | | | | | | | | | | | | 17 |

FIG. 6

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 |
|---|---|---|---|---|---|---|---|---|---|---|---|---|---|---|---|---|---|---|---|---|---|---|---|---|---|---|
| 0 | 250 | 69 | 226 | 159 | | 100 | 10 | | | 59 | 229 | 110 | 191 | 9 | | 195 | 23 | | 190 | 35 | 239 | 31 | 1 | 0 | | |
| 1 | 2 | | 239 | 117 | 124 | 71 | | 222 | 104 | 173 | | 220 | 102 | | 109 | 132 | 142 | 155 | | 255 | | 28 | 0 | 0 | 0 | |
| 2 | 106 | 111 | 185 | | 63 | 117 | 93 | 229 | 177 | 95 | 39 | | | 142 | 225 | 225 | | 245 | 205 | 251 | 117 | | | | 0 | 0 |
| 3 | 121 | 89 | | 84 | 20 | | 150 | 131 | 243 | | 136 | 86 | 246 | 219 | 211 | | 240 | 76 | 244 | | 144 | 12 | 1 | | | 0 |
| 4 | 157 | 102 | | | | | | | | | | | | | | | | | | | | | | | | |
| 5 | 205 | 236 | | 194 | | | | | | | | | 231 | | | | 28 | | | | | 123 | 115 | | | |
| 6 | 183 | | | | | | 22 | | | | 28 | 67 | | 244 | | | | 11 | 157 | | 211 | | | | | |
| 7 | 220 | 44 | | | 159 | | | 31 | 167 | | | | | | 104 | | | | | | | | | | | |
| 8 | 112 | 4 | | 7 | | | | | | | | | 211 | | | | 102 | | | 164 | | 109 | 241 | | 90 | |
| 9 | 103 | 182 | | | | | | | | | 109 | 21 | | 142 | | | | 14 | 61 | | 216 | | | | | |
| 10 | | 98 | 149 | | 167 | | | 160 | 49 | | | | | | 58 | | | | | | | | | | | |
| 11 | 77 | 41 | | | | | | | | | | | 83 | | | | 182 | | | | | 78 | 252 | 22 | | |
| 12 | 160 | 42 | | | | | | | | | 21 | 32 | | 234 | | | | | 7 | | | | | | | |
| 13 | 177 | | | 248 | | | | 151 | | | | | | | | | | | | | 185 | | | 62 | | |
| 14 | 206 | | | | | | | | | | | | 55 | | | 206 | 127 | 16 | | | | 229 | | | | |
| 15 | 40 | 96 | | | | | | | | | 65 | | | 63 | | | | | 75 | | | | | | | 179 |
| 16 | | 64 | | 49 | | | | | | | | 49 | | | | | | | | | 51 | | 154 | | | |
| 17 | 7 | | | | | | | | | | | | | | 164 | | 59 | 1 | | | | 144 | | | | |
| 18 | | 42 | | | | | | | | | | | 233 | 8 | | | | | 155 | 147 | | | | | | |
| 19 | 60 | 73 | | | | | | 72 | 127 | | 224 | | | | | | | | | | | | | | | |
| 20 | 151 | | | 186 | | | | | | 217 | | 47 | | | | | | | | | | | 160 | | | |
| 21 | | 249 | | | | 121 | | | | | | | | | | | 109 | | | | 131 | 171 | | | | |
| 22 | 64 | | | | | | | | | | | | 142 | 188 | | | | 158 | | | | | | | | |
| 23 | | 156 | 147 | | | | | | | | 170 | | | | | | | | 152 | | | | | | | |
| 24 | 112 | | | 86 | 236 | | | | | | | 116 | | | | | | | | | | | 222 | | | |
| 25 | | 23 | | | | | 136 | 116 | | | | | | | 182 | | | | | | | | | | | |
| 26 | 195 | | 243 | | 215 | | | | | | | | | | | 61 | | | | | | | | | | |
| 27 | | 25 | | | | | 104 | | 194 | | | | | | | | | | | | | | | | | |
| 28 | 128 | | | | 165 | | | | | | | | | | | | | | | 181 | | 63 | | | | |
| 29 | | 86 | | | | | | | | | | | | | 236 | | | | 84 | | | | | | | 6 |
| 30 | 216 | | | | | | | | | | 73 | | | 120 | | | | | | | | | | | 9 | |
| 31 | | 95 | | | | | | 177 | | | | | | | | | | | | | | | 172 | | | 61 |
| 32 | 221 | | | | | | | | | | | | 112 | | 199 | | | | | | | | | | 121 | |
| 33 | | 2 | 187 | | | | | | | | | 41 | | | | | | | | | | 211 | | | | |
| 34 | 127 | | | | | | | 167 | | | | | | | | 164 | | 159 | | | | | | | | |
| 35 | | 161 | | | | | 197 | | | | | | 207 | | | | | | | | | | 103 | | | |
| 36 | 37 | | | | | | | | | | | | | | 105 | 51 | | | 120 | | | | | | | |
| 37 | | 198 | | | | | | | | | | | | 220 | | | | | | | | | | 122 | | |
| 38 | 167 | | | | | | | | | 151 | 157 | | 163 | | | | | | | | | | | | | |
| 39 | | 173 | | 139 | | | | 149 | | | | | | | | | | | | 0 | | | | | | |
| 40 | 157 | | | | | | | | 137 | | | | | | | | | 149 | | | | | | | | |
| 41 | | 167 | | 173 | | | | | | 139 | | | | | | | | | 151 | | | | | | | |
| 42 | 149 | | | | 157 | | | | | | | | | | | | | | | | | | | | 137 | |
| 43 | | 151 | | | | | | | | | | | | | | | 163 | | 173 | | | | | | | 139 |
| 44 | 139 | | | | | | | 157 | | 163 | | | | | | | | | | | | | 173 | | | |
| 45 | | 149 | | | | | 151 | | | | 167 | | | | | | | | | | | | | | | |

| | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 | 52 | 53 | 54 | 55 | 56 | 57 | 58 | 59 | 60 | 61 | 62 | 63 | 64 | 65 | 66 | 67 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 | | | | | | | | | | | | | | | | | | | | | | | | | | | | | | | | | | | | | | | | | | |
| 1 | | | | | | | | | | | | | | | | | | | | | | | | | | | | | | | | | | | | | | | | | | |
| 2 | | | | | | | | | | | | | | | | | | | | | | | | | | | | | | | | | | | | | | | | | | |
| 3 | | | | | | | | | | | | | | | | | | | | | | | | | | | | | | | | | | | | | | | | | | |
| 4 | 0 | | | | | | | | | | | | | | | | | | | | | | | | | | | | | | | | | | | | | | | | | |
| 5 | | 0 | | | | | | | | | | | | | | | | | | | | | | | | | | | | | | | | | | | | | | | | |
| 6 | | | 0 | | | | | | | | | | | | | | | | | | | | | | | | | | | | | | | | | | | | | | | |
| 7 | | | | 0 | | | | | | | | | | | | | | | | | | | | | | | | | | | | | | | | | | | | | | |
| 8 | | | | | 0 | | | | | | | | | | | | | | | | | | | | | | | | | | | | | | | | | | | | | |
| 9 | | | | | | 0 | | | | | | | | | | | | | | | | | | | | | | | | | | | | | | | | | | | | |
| 10 | | | | | | | 0 | | | | | | | | | | | | | | | | | | | | | | | | | | | | | | | | | | | |
| 11 | | | | | | | | 0 | | | | | | | | | | | | | | | | | | | | | | | | | | | | | | | | | | |
| 12 | | | | | | | | | 0 | | | | | | | | | | | | | | | | | | | | | | | | | | | | | | | | | |
| 13 | | | | | | | | | | 0 | | | | | | | | | | | | | | | | | | | | | | | | | | | | | | | | |
| 14 | | | | | | | | | | | 0 | | | | | | | | | | | | | | | | | | | | | | | | | | | | | | | |
| 15 | | | | | | | | | | | | 0 | | | | | | | | | | | | | | | | | | | | | | | | | | | | | | |
| 16 | | | | | | | | | | | | | 0 | | | | | | | | | | | | | | | | | | | | | | | | | | | | | |
| 17 | | | | | | | | | | | | | | 0 | | | | | | | | | | | | | | | | | | | | | | | | | | | | |
| 18 | | | | | | | | | | | | | | | 0 | | | | | | | | | | | | | | | | | | | | | | | | | | | |
| 19 | | | | | | | | | | | | | | | | 0 | | | | | | | | | | | | | | | | | | | | | | | | | | |
| 20 | | | | | | | | | | | | | | | | | 0 | | | | | | | | | | | | | | | | | | | | | | | | | |
| 21 | | | | | | | | | | | | | | | | | | 0 | | | | | | | | | | | | | | | | | | | | | | | | |
| 22 | | | | | | | | | | | | | | | | | | | 0 | | | | | | | | | | | | | | | | | | | | | | | |
| 23 | | | | | | | | | | | | | | | | | | | | 0 | | | | | | | | | | | | | | | | | | | | | | |
| 24 | | | | | | | | | | | | | | | | | | | | | 0 | | | | | | | | | | | | | | | | | | | | | |
| 25 | | | | | | | | | | | | | | | | | | | | | | 0 | | | | | | | | | | | | | | | | | | | | |
| 26 | | | | | | | | | | | | | | | | | | | | | | | 0 | | | | | | | | | | | | | | | | | | | |
| 27 | | | | | | | | | | | | | | | | | | | | | | | | 0 | | | | | | | | | | | | | | | | | | |
| 28 | | | | | | | | | | | | | | | | | | | | | | | | | 0 | | | | | | | | | | | | | | | | | |
| 29 | | | | | | | | | | | | | | | | | | | | | | | | | | 0 | | | | | | | | | | | | | | | | |
| 30 | | | | | | | | | | | | | | | | | | | | | | | | | | | 0 | | | | | | | | | | | | | | | |
| 31 | | | | | | | | | | | | | | | | | | | | | | | | | | | | 0 | | | | | | | | | | | | | | |
| 32 | | | | | | | | | | | | | | | | | | | | | | | | | | | | | 0 | | | | | | | | | | | | | |
| 33 | | | | | | | | | | | | | | | | | | | | | | | | | | | | | | 0 | | | | | | | | | | | | |
| 34 | | | | | | | | | | | | | | | | | | | | | | | | | | | | | | | 0 | | | | | | | | | | | |
| 35 | | | | | | | | | | | | | | | | | | | | | | | | | | | | | | | | 0 | | | | | | | | | | |
| 36 | | | | | | | | | | | | | | | | | | | | | | | | | | | | | | | | | 0 | | | | | | | | | |
| 37 | | | | | | | | | | | | | | | | | | | | | | | | | | | | | | | | | | 0 | | | | | | | | |
| 38 | | | | | | | | | | | | | | | | | | | | | | | | | | | | | | | | | | | 0 | | | | | | | |
| 39 | | | | | | | | | | | | | | | | | | | | | | | | | | | | | | | | | | | | 0 | | | | | | |
| 40 | | | | | | | | | | | | | | | | | | | | | | | | | | | | | | | | | | | | | 0 | | | | | |
| 41 | | | | | | | | | | | | | | | | | | | | | | | | | | | | | | | | | | | | | | 0 | | | | |
| 42 | | | | | | | | | | | | | | | | | | | | | | | | | | | | | | | | | | | | | | | 0 | | | |
| 43 | | | | | | | | | | | | | | | | | | | | | | | | | | | | | | | | | | | | | | | | 0 | | |
| 44 | | | | | | | | | | | | | | | | | | | | | | | | | | | | | | | | | | | | | | | | | 0 | |
| 45 | | | | | | | | | | | | | | | | | | | | | | | | | | | | | | | | | | | | | | | | | | 0 |

FIG. 7

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 |
|---|---|---|---|---|---|---|---|---|---|---|---|---|---|---|---|---|---|---|---|---|---|---|---|---|---|---|
| 0 | 250 | 69 | 226 | 159 || 100 | 10 ||| 59 | 229 | 110 | 191 | 9 || 195 | 23 || 190 | 35 | 239 | 31 | 1 | 0 |||
| 1 | 2 || 239 | 117 | 124 | 71 || 222 | 104 | 173 || 220 | 102 || 109 | 132 | 142 | 155 || 255 || 28 | 0 | 0 | 0 ||
| 2 | 106 | 111 | 185 || 63 | 117 | 93 | 229 | 177 | 95 | 39 ||| 142 | 225 | 225 || 245 | 205 | 251 | 117 |||| 0 | 0 |
| 3 | 121 | 89 || 84 | 20 || 150 | 131 | 243 || 136 | 86 | 246 | 219 | 211 || 240 | 76 | 244 || 144 | 12 | 1 ||| 0 |
| 4 | 157 | 102 ||||||||||||||||||||||||
| 5 | 90 | 121 || 79 ||||||||| 116 |||| 169 ||||| 8 | 0 ||||
| 6 | 183 |||||| 22 |||| 28 | 67 || 244 |||| 11 | 157 || 211 ||||||
| 7 | 220 | 44 ||| 159 ||| 31 | 167 |||||| 104 ||||||||||||
| 8 | 127 | 19 || 22 ||||||||| 226 |||| 117 ||| 179 || 124 | 0 || 105 ||
| 9 | 103 | 182 ||||||||| 109 | 21 || 142 |||| 14 | 61 || 216 ||||||
| 10 || 98 | 149 || 167 ||| 160 | 49 |||||| 58 ||||||||||||
| 11 | 81 | 45 ||||||||||| 87 |||| 186 ||||| 82 | 0 | 26 |||
| 12 | 160 | 42 ||||||||| 21 | 32 || 234 ||||| 7 ||||||||
| 13 | 115 ||| 186 |||| 89 ||||||||||||| 123 ||| 0 |||
| 14 | 206 |||||||||||| 55 ||| 206 | 127 | 16 |||| 229 |||||
| 15 | 117 | 173 ||||||||| 142 ||| 140 ||||| 152 ||||||| 0 |
| 16 || 166 || 151 |||||||| 151 ||||||||| 153 || 0 ||||
| 17 | 7 |||||||||||||| 164 || 59 | 1 |||| 144 |||||
| 18 || 42 ||||||||||| 233 | 8 ||||| 155 | 147 |||||||
| 19 | 60 | 73 |||||| 72 | 127 || 224 ||||||||||||||||
| 20 | 247 ||| 26 |||||| 57 || 143 ||||||||||| 0 ||||
| 21 || 249 |||| 121 ||||||||||| 109 |||| 131 | 171 |||||
| 22 | 64 |||||||||||| 142 | 188 |||| 158 |||||||||
| 23 || 156 | 147 |||||||| 170 |||||||| 152 ||||||||
| 24 | 146 ||| 120 | 14 ||||||| 150 ||||||||||| 0 ||||
| 25 || 23 ||||| 136 | 116 ||||||| 182 ||||||||||||
| 26 | 195 || 243 || 215 ||||||||||| 61 |||||||||||
| 27 || 25 ||||| 104 || 194 ||||||||||||||||||
| 28 | 128 |||| 165 ||||||||||||||| 181 || 63 |||||
| 29 || 80 ||||||||||||| 230 |||| 78 ||||||| 0 |
| 30 | 207 |||||||||| 64 ||| 111 ||||||||||| 0 ||
| 31 || 179 |||||| 5 ||||||||||||||| 0 ||| 145 |
| 32 | 100 |||||||||||| 247 || 78 |||||||||| 0 ||
| 33 || 2 | 187 ||||||||| 41 |||||||||| 211 |||||
| 34 | 127 ||||||| 167 |||||||| 164 || 159 |||||||||
| 35 || 58 ||||| 94 |||||| 104 |||||||||| 0 ||||
| 36 | 37 |||||||||||||| 105 | 51 ||| 120 ||||||||
| 37 || 76 |||||||||||| 98 |||||||||| 0 |||
| 38 | 167 ||||||||| 151 | 157 || 163 ||||||||||||||
| 39 || 173 || 139 |||| 149 |||||||||||| 0 |||||||
| 40 | 157 |||||||| 137 ||||||||| 149 |||||||||
| 41 || 167 || 173 |||||| 139 ||||||||| 151 ||||||||
| 42 | 12 |||| 20 |||||||||||||||||||| 0 ||
| 43 || 12 ||||||||||||||| 24 || 34 ||||||| 0 |
| 44 | 222 ||||||| 240 || 246 ||||||||||||| 0 ||||
| 45 || 149 ||||| 151 |||| 167 ||||||||||||||||

| | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 | 52 | 53 | 54 | 55 | 56 | 57 | 58 | 59 | 60 | 61 | 62 | 63 | 64 | 65 | 66 | 67 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 0 ||||||||||||||||||||||||||||||||||||||||||||
| 1 ||||||||||||||||||||||||||||||||||||||||||||
| 2 ||||||||||||||||||||||||||||||||||||||||||||
| 3 ||||||||||||||||||||||||||||||||||||||||||||
| 4 | 0 |||||||||||||||||||||||||||||||||||||||||
| 5 || 141 ||||||||||||||||||||||||||||||||||||||||
| 6 ||| 0 |||||||||||||||||||||||||||||||||||||||
| 7 |||| 0 ||||||||||||||||||||||||||||||||||||||
| 8 ||||| 15 |||||||||||||||||||||||||||||||||||||
| 9 |||||| 0 ||||||||||||||||||||||||||||||||||||
| 10 ||||||| 0 |||||||||||||||||||||||||||||||||||
| 11 |||||||| 4 ||||||||||||||||||||||||||||||||||
| 12 ||||||||| 0 |||||||||||||||||||||||||||||||||
| 13 |||||||||| 194 ||||||||||||||||||||||||||||||||
| 14 ||||||||||| 0 |||||||||||||||||||||||||||||||
| 15 |||||||||||| 77 ||||||||||||||||||||||||||||||
| 16 ||||||||||||| 102 |||||||||||||||||||||||||||||
| 17 |||||||||||||| 0 ||||||||||||||||||||||||||||
| 18 ||||||||||||||| 0 |||||||||||||||||||||||||||
| 19 |||||||||||||||| 0 ||||||||||||||||||||||||||
| 20 ||||||||||||||||| 96 |||||||||||||||||||||||||
| 21 |||||||||||||||||| 0 ||||||||||||||||||||||||
| 22 ||||||||||||||||||| 0 |||||||||||||||||||||||
| 23 |||||||||||||||||||| 0 ||||||||||||||||||||||
| 24 ||||||||||||||||||||| 34 |||||||||||||||||||||
| 25 |||||||||||||||||||||| 0 ||||||||||||||||||||
| 26 ||||||||||||||||||||||| 0 |||||||||||||||||||
| 27 |||||||||||||||||||||||| 0 ||||||||||||||||||
| 28 ||||||||||||||||||||||||| 0 |||||||||||||||||
| 29 |||||||||||||||||||||||||| 250 ||||||||||||||||
| 30 ||||||||||||||||||||||||||| 247 |||||||||||||||
| 31 |||||||||||||||||||||||||||| 84 ||||||||||||||
| 32 ||||||||||||||||||||||||||||| 135 |||||||||||||
| 33 |||||||||||||||||||||||||||||| 0 ||||||||||||
| 34 ||||||||||||||||||||||||||||||| 0 |||||||||||
| 35 |||||||||||||||||||||||||||||||| 153 ||||||||||
| 36 ||||||||||||||||||||||||||||||||| 0 |||||||||
| 37 |||||||||||||||||||||||||||||||||| 134 ||||||||
| 38 ||||||||||||||||||||||||||||||||||| 0 |||||||
| 39 |||||||||||||||||||||||||||||||||||| 0 ||||||
| 40 ||||||||||||||||||||||||||||||||||||| 0 |||||
| 41 |||||||||||||||||||||||||||||||||||||| 0 ||||
| 42 ||||||||||||||||||||||||||||||||||||||| 119 |||
| 43 |||||||||||||||||||||||||||||||||||||||| 117 ||
| 44 ||||||||||||||||||||||||||||||||||||||||| 83 |
| 45 |||||||||||||||||||||||||||||||||||||||||| 0 |

FIG. 8

901
Memory
Processor
902

FIG. 9

**INTERNATIONAL SEARCH REPORT**

International application No. **PCT/CN2020/102814**

**A. CLASSIFICATION OF SUBJECT MATTER**

H03M 13/11(2006.01)i; H04L 1/00(2006.01)i

According to International Patent Classification (IPC) or to both national classification and IPC

**B. FIELDS SEARCHED**

Minimum documentation searched (classification system followed by classification symbols)

H03M; H04L

Documentation searched other than minimum documentation to the extent that such documents are included in the fields searched

Electronic data base consulted during the international search (name of data base and, where practicable, search terms used)

WPI, EPODOC, CNPAT, CNKI: 低密度奇偶校验码, 编码, 扩展, 因子, 系数, 提升值, 分段, 分块, 码块, 分割, 划分, 移位, 偏移, 校验, 信息, LDPC, Low Density Parity Check, coding, spreading factor, shift size, lift size, segmentation, blocking, offset, verification

**C. DOCUMENTS CONSIDERED TO BE RELEVANT**

| Category* | Citation of document, with indication, where appropriate, of the relevant passages | Relevant to claim No. |
|---|---|---|
| Y | CN 101431396 A (MATSUSHITA ELECTRIC INDUSTRY CO., LTD.) 13 May 2009 (2009-05-13)<br>description page 1 paragraph 3- page 2 paragraph 3, figure 2 | 1-3, 6-8, 11-12 |
| Y | CN 107370488 A (ZTE CORPORATION) 21 November 2017 (2017-11-21)<br>description, paragraphs [0071]-[0084] | 1-3, 6-8, 11-12 |
| A | CN 108347297 A (HUAWEI TECHNOLOGIES CO., LTD.) 31 July 2018 (2018-07-31)<br>entire document | 1-12 |
| A | CN 101141133 A (BEIJING UNIVERSITY OF POSTS AND TELECOMMUNICATIONS et al.) 12 March 2008 (2008-03-12)<br>entire document | 1-12 |
| A | US 2019207710 A1 (IDAC HOLDINGS, INC.) 04 July 2019 (2019-07-04)<br>entire document | 1-12 |

☐ Further documents are listed in the continuation of Box C. ☑ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **28 September 2020** | **27 October 2020** |

Name and mailing address of the ISA/CN

**China National Intellectual Property Administration (ISA/CN)**
**No. 6, Xitucheng Road, Jimenqiao Haidian District, Beijing 100088**
**China**

Facsimile No. **(86-10)62019451**

Authorized officer

Telephone No.

Form PCT/ISA/210 (second sheet) (January 2015)

**INTERNATIONAL SEARCH REPORT**
**Information on patent family members**

International application No.
**PCT/CN2020/102814**

| Patent document cited in search report | | | Publication date (day/month/year) | Patent family member(s) | | | Publication date (day/month/year) |
|---|---|---|---|---|---|---|---|
| CN | 101431396 | A | 13 May 2009 | WO | 2009060628 | A1 | 14 May 2009 |
| CN | 107370488 | A | 21 November 2017 | WO | 2017194013 | A1 | 16 November 2017 |
| CN | 108347297 | A | 31 July 2018 | US | 2019349004 | A1 | 14 November 2019 |
| | | | | WO | 2018137663 | A1 | 02 August 2018 |
| | | | | EP | 3553984 | A1 | 16 October 2019 |
| | | | | | IN201937027483 | A | 23 August 2019 |
| CN | 101141133 | A | 12 March 2008 | | None | | |
| US | 2019207710 | A1 | 04 July 2019 | EP | 3497794 | A1 | 19 June 2019 |
| | | | | CN | 109792254 | A | 21 May 2019 |
| | | | | WO | 2018031777 | A1 | 15 February 2018 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 201910754120